# EUROPÄISCHE PATENTSCHRIFT

(11) **EP 1 868 248 B1**
(45) Veröffentlichungstag und Bekanntmachung des Hinweises auf die Patenterteilung: **11.07.2012**
(21) Anmeldenummer: 06012193.6
(22) Anmeldetag: 13.06.2006
(51) Int. Cl.: H01L 31/042, H01L 31/048, G08B 13/24, G06K 19/07

(54) **Diebstahlschutzanlage für eine Photovoltaikanlage**
Anti-theft device for a photovoltaic installation
Dispositif de protection d'une installation photovoltaique contre le vol

(43) Veröffentlichungstag der Anmeldung: 19.12.2007
(73) Patentinhaber: Schneider, Andreas, 72149 Neustetten-Wolfenhausen (DE)
(72) Erfinder: Schneider, Andreas, 72149 Neustetten-Wolfenhausen (DE)
(74) Vertreter: Späth, Dieter

(56) Entgegenhaltungen:
- EP-A2- 0 978 884
- WO-A-00/21032
- BE-A6- 1 012 912
- JP-A- 2002 367 046
- US-A- 6 121 880
- US-A1- 2005 224 109
- US-A1- 2005 270 159

## Beschreibung

Die Erfindung betrifft eine Diebstahlschutzanlage für eine Photovoltaikanlage, wobei die Photovoltaikanlage mindestens ein Solarmodul aufweist, das auf einem Halter befestigt ist. Ein Solarmodul ist üblicherweise plattenförmig und weist in einer Ebene angeordnete Solarzellen auf.

Die Nutzung regenerativer Energien wie z. B. der Sonnenenergie gewinnt auf Grund der hohen Energiekosten, dem steigenden Umweltbewusstsein sowie der Verknappung fossiler Brennstoffe zunehmend an Bedeutung. Insbesondere ermöglichen immer leistungsfähigere Solarmodule weitreichende Anwendungen. So haben sich Solarmodule durch ihre hohe Leistungsfähigkeit, Wartungsfreiheit und einfache Anwendbarkeit zur Erzeugung von elektrischem Strom durchgesetzt.

Es ist bekannt, eine Anzahl von Solarmodulen zu Photovoltaikanlagen zusammen zu fassen. Der von den Solarmodulen erzeugte elektrische Strom wird von der Anlage in das öffentliche Netz eingespeist bzw. am Erzeugungsort vom Verbraucher verbraucht. Derartige Photovoltaikanlagen werden beispielsweise auf Dächern von Industriehallen, von größeren Wohngebäuden, aber auch auf Dächern von Einfamilienhäusern angeordnet. Es ist weiterhin bekannt, derartige Anlagen auf Gestellen am Boden zu montieren, wenn ausreichend Platz dazu vorhanden ist.

Die Befestigung der Solarmodule erfolgt üblicherweise mit Hilfe von Klammern, die jeweils den Rand eines Moduls umgreifen und ihrerseits mit einem gestellartigen Halter, der auf dem Dach eines Gebäudes oder dem Boden angeordnet ist, und das oder die Solarmodule üblicherweise geneigt hält, lösbar verbunden sind. Die Festlegung der Klammern an dem Halter erfolgt dabei in der Regel mit Schrauben und Muttern.

Es hat sich gezeigt, dass die teueren Solarmodule von Photovoltaikanlagen ein begehrtes Diebstahlsobjekt sind und dass die Schraubbefestigung der Solarmodule für potenzielle Diebe eine unproblematische Befestigung darstellt, so dass die Sicherung der Photovoltaikanlage durch Sicherheitsalarmvorrichtungen oder dergleichen nicht nur wünschenswert, sondern eigentlich erforderlich ist. insbesondere sind dabei Photovoltaikanlagen gefährdet, die leicht zugänglich sind oder in abgelegenen Gebieten betrieben werden. Die Verwendung sogenannter diebstahlsicherer Schrauben hat sich nicht als wirksamer Diebstahlschutz erwiesen.

Diebstahlschutzanlagen die mit einem Funk-Kommunikationssystem arbeiten, sind an sich in vielfältigen Ausführungsformen bekannt. Zum Stand der Technik wird beispielhaft auf die BE 1 012 912 A6, die US 2005/224109 A1 und die WO 00/21032 A verwiesen.

Die belgische Patentanmeldung BE 1 012 912 A6 hat einen Diebstahlschutz für Fahrzeuge und andere verlagerbare Geräte zum Gegenstand. Die Patentanmeldung listet eine große Anzahl solcher Geräte und Gegenstände auf, darunter auch Solarpanele. Der Gedanke dieser Anmeldung ist, ein GPS-Ortungssystem so in den zu schützenden Gegenstand zu integrieren, dass das Ortungssystem nicht zerstörungsfrei vom Gegenstand entfernt werden kann. Beispielsweise wird das Ortungssystem in die Elektronik, also beispielsweise die Zündung eines Kraftwagens integriert. Das Entfernen oder Zerstören des Ortungssystems beschädigt den gesicherten Gegenstand oder macht ihn unbrauchbar, so dass der gesicherte Gegenstand zur weiteren Verwendung repariert werden muss. Im Beispielsfall wird durch Zerstörung des Ortungssystems die Zündanlage des Kraftwagens zerstört, so dass dieser nicht mehr gestartet werden kann. Wird das Ortungssystem nicht zerstört, lässt sich der gesicherte Gegenstand orten.

Gegenstand der Patentanmeldung US 2005/0224109 A1 ist ein Solarmodul, das bei Ausgestaltungen elektronische Komponenten, beispielsweise RFID Chips enthalten kann. Der Diebstahlschutzchip wird aktiviert, wenn das Solarmodul ohne Genehmigung von einem Stromkreis getrennt wird, dabei unterbricht der Diebstahlschutzchip den Stromkreis des Solarmoduls, so dass das Solarmodul unbrauchbar ist.

Die internationale Patentanmeldung WO 00/21 032 ist auf das Integrieren oder Anbringen von RFID Transpondern an elektronischen Chips, elektronischen Baugruppen oder anderen zu schützenden Komponenten, also beispielsweise auch an Computergehäusen gerichtet. Unter anderem können Ausgänge von Büros mit Empfängern ausgerüstet werden, die ein Warnsignal abgeben, wenn ein Computer, der mit einem RFID Chip ausgerüstet ist, durch den Ausgang entfernt wird.

Der Erfindung liegt die Aufgabe zu Grunde, eine Diebstahlschutzanlage mit guter Wirksamkeit für eine Photovoltaikanlage vorzuschlagen.

Diese Aufgabe wird erfindungsgemäß durch eine Diebstahlschutzanlage mit den Merkmalen des Anspruchs 1 gelöst. Weitere vorteilhafte Ausgestaltungen sind den Unteransprüchen zu entnehmen.

Die erfindungsgemäße Diebstahlschutzanlage verwendet eine Detektionseinrichtung mit Sender und Empfänger auf Basis eines Code-Signal-Austausches mittels elektromagnetischer Funkwellen. Eine bekannte und für viele Anwendungen ausgereifte Technik wird unter der Bezeichnung "Radio-Frequenz-Identifikation" (RFID) zusammengefasst, die auch als Funkerkennung bezeichnet wird.

RFID gestützte Detektionseinrichtungen bestehen aus einem oder mehreren an verschiedenen zu überwachenden Orten fest angebrachten Sende-Empfangs-Einheiten und Codesendern, welche oft auch als Transponder ausgebildet sind. Transponder bestehen im Wesentlichen aus einem Chip mit einem Prozessor und einem Speicher sowie einer Sende- und Empfangsantenne für die Datenübertragung. Wann immer der Transponder in die Nähe einer Sende-Empfangs-Einheit kommt, sendet er einen in dem Speicher des Transponders hinterlegten unverwechselbaren Code aus, wodurch dessen Träger eindeutig identifiziert werden kann. Zur Überwachung eines Gegenstandes muss der Transponder auf diesem angebracht und unlösbar befestigt werden.

Gegenüber anderen Markierungstechniken haben Transponder den Vorteil, dass sie sich berührungslos und ohne jeden Sichtkontakt auslesen lassen. Je nach Bauart lassen sich Leseabstände von vielen Metern realisieren, wobei für die Erfindung ein kurzer Leseabstand eines passiven Transponders mit wenigen Zentimetern ausreicht und bevorzugt wird. Man unterscheidet aktive Transponder mit einer eigenen Energieversorgung und passive Transponder ohne eigene Energiequelle, welche im Erfassungsbereich einer Sende-Empfangs-Einheit von dieser berührungslos mit Energie versorgt werden. Durch einen unitären Code, der in jedem Transponder gespeichert ist, lassen sich Gegenstände eindeutig identifizieren und wenn erforderlich geeignete Maßnahmen auslösen.

Erfindungsgemäß weist das Solarmodul einen Transponder und die Diebstahlschutzanlage eine Sende-Empfangs-Einheit zur Datenübertragung mit dem Transponder auf-, die dem Transponder gegenüberliegend angeordnet und am Halter fixiert ist. Das Solarmodul deckt den Transponder und die Sende-Empfangs-Einheit unzugänglich ab, so dass die Sende-Empfangs-Einheit nur abgekoppelt und der Transponder nur gelöst werden können wenn zuvor das Solarmodul vom Halter gelöst wird. Die Sende-Empfangs-Einheit detektiert ein Solarmodul mittels seinem Transponder und liest bzw. decodiert die von diesem übermittelten Daten. Dabei kommen passive Transponder zum Einsatz, die die zur Kommunikation benötigte Energie ausschließlich aus dem elektromagnetischen Feld beziehen, das die Sende-Empfangs-Einheit der Diebstahlschutzanlage ausstrahlt. Diese liest die Daten des Transponders berührungslos und ohne Sichtkontakt, sobald das Solarmodul in das elektromagnetische Feld der Sende-Empfangs-Einheit eintritt und/oder von der Sende-Empfangseinheit dazu aufgefordert wird. Antwortet der Transponder nicht auf eine Aufforderung der Sende-Empfangs-Einheit, meldet die Diebstahlschutzanlage das. Dabei werden Transponder und Sende-Empfangs-Einheitein mit einem kurzem Leseabstand eingesetzt, die jeweils nahe beieinander angeordnet sind, was den Vorteil hat, dass bereits ein geringes Anheben eines Solarmoduls vom Halter detektiert wird. Um den Transponder oder die Sende-Empfangs-Einheit manipulieren zu können muss das Solarmodul so weit angehoben werden, dass es die Diebstahlschutzanlage meldet.

Die erfindungsgemäße Diebstahlschutzanlage ist bei neu zu erstellenden Photovoltaikanlagen ebenso einsetzbar wie bei bestehenden Anlagen nachrüstbar. Durch eine vorteilhafte Anordnung und technische Auslegung der Sende-Empfangs-Einheit kann auch das Vorhandensein von mehreren Transpondern gleichzeitig von einer Sende-Empfangs-Einheit detektiert werden, so dass nicht zwingend jedem Transponder eine eigene Sende-Empfangs-Einheit zugeordnet werden muss.

Eine derartige Diebstahlschutzanlage stellt somit in vorteilhafter Art und Weise eine einfache und kostengünstig herzustellende Sicherung gegen einen Diebstahl von Solarmodulen zur Verfügung. Sie kann mit einer Alarmeinrichtung gekoppelt sein, die beim Entfernen eines Solarmoduls aus dem Erfassungsbereich einer Sende-Empfangs-Einheit beispielsweise einen optischen und/oder akustischen Alarm auslöst, der über eine größere Distanz wahrnehmbar ist und damit den Dieb abschreckt und Passanten aufmerksam macht. Die Diebstahlschutzanlage kann eine unberechtigte Entfernung von Solarmodulen auch melden ohne den Dieb aufzuschrecken, indem sie den Betreiber der Photovoltaikanlage, einen Sicherheitsdienst oder die Polizei über eine vorgesehene Kommunikationseinrichtung alarmiert (stiller Alarm). Es kann auch hilfreich sein, die Alarmmittel für jedermann gut sichtbar anzubringen und/oder mit einem von weitem sichtbaren Hinweisschild auf die Diebstahlschutzanlage zu verweisen.

Die Diebstahlschutzanlage ist weitgehend manipulationssicher, da die Sende-Empfangs-Einheiten sowie die Transponder der Photovoltaikanlage unauffällig an den Solarmodulen und/oder dem Halter angeordnet und insbesondere auch nicht ohne Weiteres erreichbar sind. Bei der erfindungsgemäßen Diebstahlschutzanlage für eine Photovoltaikanlage ist der Transponder vom Solarmodul abgedeckt und unzugänglich, solange das Solarmodul an dem Halter befestigt ist. Dabei können die Transponder beispielsweise auf der Rückseite der Solarmodule dem Halter gegenüberliegend angeordnet sein, so dass sie von dem Halter abgedeckt sind. In ähnlicher Weise können auch die Sende-Empfangs-Einheiten an dem Halter vor Manipulation geschützt werden. Somit können die Sende-Empfangs-Einheiten von der Diebstahlschutzanlage nur abgekoppelt bzw. die Transponder von den Solarmodulen gelöst werden, wenn zuvor die Solarmodule von dem Halter gelöst werden. Zum Erreichen der Transponder sowie der Sende-Empfangs-Einheiten müssen die Solarmodule vom dem Halter entfernt werden, wobei die Transponder aus dem Erfassungsbereich der Sende-Empfangs-Einheiten gelangen und der Alarm ausgelöst wird.

Es ist möglich den Transponder des Solarmoduls außen an dem Solarmodul anzubringen, beispielsweise auf dessen Unterseite aufzukleben, oder in das Solarmodul zu integrieren. Vorzugsweise ist er in das Solarmodul laminiert, wodurch er vor Umwelteinflüssen, unbeabsichtigter Beschädigung bzw. unberechtigter Manipulation sicher geschützt ist. Außerdem kann der Transponder bereits bei der Herstellung des Solarmoduls programmiert und geprüft werden, was den Zeitaufwand für die Montage der Photovoltaikanlage reduziert und die Inbetriebnahme vor Ort wesentlich vereinfacht.

In einer anderen vorteilhaften Ausgestaltung der erfindungsgemäßen Diebstahlschutzanlage ist der Transponder als Klebeetikett ausgebildet und weist einen Aufdruck auf, der nicht auf einen Transponder hinweist. Der Aufdruck des Klebeetikettes kann beispielsweise einen Hinweis auf den Hersteller oder die Montage des Solarmoduls enthalten. Es ist auch möglich, die Service-Anschrift des Herstellers und/oder die Bezeichnung des Solarmoduls oder eine Werbung aufzudrucken. So können einerseits die entsprechenden Klebeschilder, die nur der Information dienen, entfallen und andererseits der Transponder als Informationsschild getarnt werden. Eine derartige Ausführungsform des Transponders verschleiert das Vorhandensein der Diebstahlschutzeinrichtung für das Solarmodul und beugt einem Manipulationsversuch vor.

Die Diebstahlschutzanlage dient zur Alarmierung von Passanten, dem Betreiber der Photovoltaikanlage und/oder von Sicherheitsdiensten bzw. der Polizei. Sie kann nicht nur ein Alarmsignal in unmittelbarer Nähe der Photovoltaikanlage mittels dort vorgesehener Alarmeinrichtungen, beispielsweise Sirenen oder Signalleuchten, auslösen, sondern auch Personen an einem von der Photovoltaikanlage entfernten Standort alarmieren. Dazu weist die erfindungsgemäße Diebstahlschutzanlage vorteilhafterweise eine Fernüberwachung auf, an die die Sende-Empfangs-Einheit angeschlossen ist und die eine Entfernung des Transponders von der Sende-Empfangs-Einheit meldet.

Die Fernüberwachung ist mit der Diebstahlschutzanlage schaltungs- und/oder signaltechnisch gekoppelt und mittels Signalleitungen per Kabel oder Funk mit einem entsprechenden Anzeige- oder Ausgabegerät am entfernten Standort verbunden. Die elektronische Fernüberwachung ermöglicht zusätzlich zur Alarmierung beispielsweise auch die Übertragung von optischen und/oder akustischen Signalen aus dem Bereich der Photovoltaikanlage. Auch die Anbindung der Diebstahlschutzanlage an ein Telefonsystem ist möglich, welche im Alarmfall Personen durch eine automatisch gewählte Telefonnummer informiert. Eine Fernüberwachung zur Betriebsdatenerfassung und Funktionsüberwachung einer Photovoltaikanlage ist oftmals vorhanden und erfordert in diesem Fall keine zusätzlichen Kosten.

In einer weiteren vorteilhaften Ausführungsform der Erfindung, mit mehreren zu einer Photovoltaikanlage gekoppelten Solarmodulen, weisen einzelne Solarmodule einen Transponder auf, wobei jedem Transponder jeweils eine Sende-Empfangs-Einheit zugeordnet ist. Die mit Transpondern ausgestatteten Solarmodule sind über die Photovoltaikanlage verteilt an definierten Positionen angeordnet. Dabei ist die Lage der überwachten Solarmodule nicht ohne Weiteres erkennbar. So ist es möglich, mit einer gegenüber der Anzahl der Solarmodule geringeren Anzahl von Transpondern und Sende-Empfangs-Einheiten die Photovoltaikanlage hinreichend zu schützen und die Kosten für die Diebstahlschutzanlage zu reduzieren.

Bevorzugte Positionen für die Anordnung einzelner mit Transpondern ausgerüsteter Solarmodule sind am Rand der Photovoltaikanlage. Dies hängt damit zusammen, dass bei einer Photovoltaikanlage, mit einer Anzahl von in einer oder mehreren Reihen nebeneinander angeordneten Solarmodulen, die am Rand der Anlage befindlichen Solarmodule besonders einfach von dem jeweiligen Halter lösbar sind. Sie liegen somit für einen potenziellen Dieb an einer bevorzugten und leicht erreichbaren Position. Durch den Schutz des Randes der Photovoltaikanlage wird in der Regel die gesamte Anlage wirksam vor einem Diebstahl von Solarmodulen geschützt.

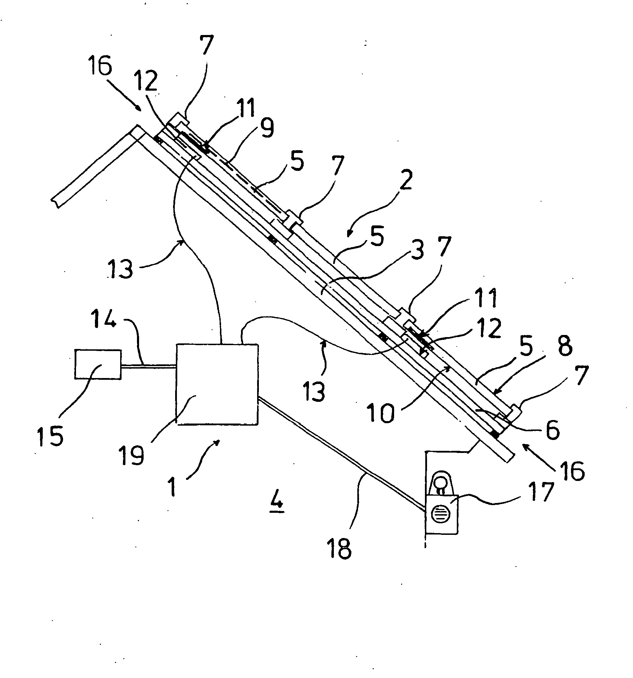

Nachfolgend wird die Erfindung anhand eines in der Zeichnung dargestellten Ausführungsbeispiels näher erläutert. Weitere Merkmale der Erfindung ergeben sich aus der folgenden Beschreibung des Ausführungsbeispiels der Erfindung in Verbindung mit den Ansprüchen und der beigefügten Zeichnung. Die einzelnen Merkmale können für sich oder zu mehreren bei unterschiedlichen Ausführungsformen der Erfindung verwirklicht sein.

Die einzige Figur der Zeichnung zeigt eine erfindungsgemäße Diebstahlschutzanlage für eine Photovoltaikanlage in einer schematischen Darstellung.

Die erfindungsgemäße Diebstahlschutzanlage 1 für eine Photovoltaikanlage 2 ist auf einer geneigten Dachhaut 3 eines Gebäudes 4 angeordnet. Die Photovoltaikanlage 2 weist eine Anzahl von nebeneinander angeordneten Solarmodulen 5 auf, die auf einem als Gestell ausgebildeten Halter 6 mittels Befestigungsklammern 7 lösbar befestigt sind. Der Halter 6 ist an der Dachhaut 3 des Gebäudes 4 festgelegt.

Die Solarmodule 5 weisen an einer von der Dachhaut 3 entfernten Oberseite 8 Solarzellen 9 zur Erzeugung von Strom auf. Auf einer der Dachhaut 3 zugewandten Unterseite 10 der Solarmodule 5 sind im Bereich des Halters 6 jeweils ein Transponder 11 sowie eine Sende-Empfangs-Einheit 12 der Diebstahlschutzanlage 1 einander gegenüberliegend angeordnet. Der Transponder 11 ist auf die Unterseite 10 des Solarmoduls 5 aufgeklebt und die Sende-Empfangs-Einheit 12 am Halter 6 fixiert.

Die Transponder 11 sowie die Sende-Empfangs-Einheiten 12 sind Teil der Diebstahlschutzanlage 1, wobei die Sende-Empfangs-Einheiten 12 jeweils mit elektrischen Verbindungsleitungen 13 mit einer elektronischen Steuerung 19 der Diebstahlschutzanlage 1 verbunden sind. Die Transponder 11 der Solarmodule 5 sind passiv ausgebildet, so dass von diesen zur Steuerung 19 keine Kabelverbindung erforderlich ist. Sie beziehen die benötigte Energie durch induktive Kopplung mit den Sende-Empfangs-Einheiten 12.

Die Transponder 11 sowie die Sende-Empfangs-Einheiten 12 sind von den entsprechenden Solarmodulen 5 abgedeckt und unzugänglich, solange die Solarmodule 5 an dem Halter 6 mittels der Befestigungsklammern 7 befestigt sind. Die elektronische Steuerung 19 der Diebstahlschutzanlage 1 ist über eine Signalleitung 14 mit einer Fernüberwachung 15 gekoppelt, die eine Entfernung eines Solarmoduls 5 zusammen mit dem zugehörigen Transponder 11 von der Sende-Empfangs-Einheit 12 bzw. eine Manipulation des entsprechenden Transponders 11 meldet. Dabei werden vorzugsweise Solarmodule 5 überwacht, die an einem äußeren Rand 16 der Photovoltaikanlage 2 angeordnet sind. Des Weiteren sind Alarmeinrichtungen 17 zur optischen und akustischen Alarmsignalisierung vorgesehen, die mit der Diebstahlschutzanlage 1 über eine Steuerleitung 18 verbunden sind.

## Patentansprüche

1. Diebstahlschutzanlage (1) für eine Photovoltaikanlage (2), wobei die Photovoltaikanlage (2) mindestens ein Solarmodul (5) aufweist, das auf einem Halter (6) befestigt ist, **dadurch gekennzeichnet, dass** das Solarmodul (5) einen passiven Transponder (11) auf der Rückseite und die Diebstahlschutzanlage (1) eine Sende-Empfangs-Einheit (12) zur Datenübertragung mit dem Transponder (11) aufweist, die für einen kurzen Leseabstand ausgebildet und dem Transponder (11) gegenüberliegend angeordnet und am Halter (6) fixiert ist und die den Transponder (11) berührungslos mit Energie versorgt, wobei der Transponder (11) und die Sende-Empfangs-Einheit (12) vom Solarmodul (5) abgedeckt und unzugänglich sind, solange das Solarmodul (5) am Halter (6) befestigt ist, so dass die Sende-Empfangs-Einheit (12) nur abgekoppelt und der Transponder (11) nur von dem Solarmodul (5) gelöst werden kann, wenn das Solarmodul (5) zuvor von dem Halter (6) gelöst wird.

2. Diebstahlschutzanlage nach Anspruch 1, **dadurch gekennzeichnet, dass** der Transponder (11) in das Solarmodul (5) laminiert ist.

3. Diebstahlschutzanlage nach einem der Ansprüche 1 bis 2, **dadurch gekennzeichnet, dass** der Transponder (11) als Klebeetikett ausgebildet ist und einen Aufdruck aufweist, der nicht auf einen Transponder (11) hinweist.

4. Diebstahlschutzanlage nach einem der Ansprüche 1 bis 3, **dadurch gekennzeichnet, dass** die Diebstahlschutzanlage (1) eine Fernüberwachung (15) aufweist, an die die Sende-Empfangs-Einheit(12) angeschlossen ist und die eine Entfernung des Transponders (11) von der Sende-Empfangs-Einheit (12) meldet.

5. Diebstahlschutzanlage nach einem der Ansprüche 1 bis 4, **dadurch gekennzeichnet, dass** die Photovoltaikanlage (2) mehrere Solarmodule (5) aufweist, von denen einzelne einen Transponder (11) aufweisen, und dass jedem Transponder (11) eine Sende-Empfangs-Einheit (12) zugeordnet ist.

6. Diebstahlschutzanlage nach Anspruch 5, **dadurch gekennzeichnet, dass** Solarmodule (5), die am Rand (16) der Photovoltaikanlage (2) angeordnet sind, einen Transponder (11) aufweisen.

## Claims

1. Anti-theft device (1) for a photovoltaic installation (2), whereby the photovoltaic installation (2) has at least one solar module (5) which is fixed on a support (6) **characterised in that** the solar module (5) has a passive transponder (11) on the back and the anti-theft device (1) has a send-and-receive unit (12) for transmitting data with the transponder (11), which is designed for a close reading distance, is disposed opposite the transponder (11) and fixed to the support (6) and which supplies the transponder with energy contact-free, whereby the transponder (11) and the send-and-receive unit (12) are covered by the solar module (5) and are not accessible as long as the solar module (5) is fixed to the support (6) so that the send-and-receive unit (12) can only be uncoupled and the transponder only released by the solar module (5) if the solar module (5) has first been released from the support (6).

2. Anti-theft device according to claim 1 **characterised in that** the transponder (11) is laminated in the solar module (5).

3. Anti-theft device according to any one of claims 1 to 2 **characterised in that** the transponder (11) is designed as an adhesive label and has printing on it which makes no reference to a transponder (11).

4. Anti-theft device according to any one of claims 1 to 3 **characterised in that** the anti-theft device (1) has a remote monitoring unit (15) to which the send-and-receive unit (12) is connected and which reports the distance of the transponder (11) from the send-and-receive unit (12).

5. Anti-theft device according to any one of claims 1 to 4 **characterised in that** the photovoltaic installation (2) has a number of solar modules (5), individual ones of which have a transponder (11), and that one send-and-receive unit (12) is allocated to each transponder (11).

6. Anti-theft device according to claim 5 **characterised in that** solar modules (5) which are disposed on the edge (16) of the photovoltaic installation (2) have a transponder (11).

## Revendications

1. Dispositif antivol (1) dévolu à une installation photovoltaïque (2), ladite installation photovoltaïque (2) comportant au moins un module solaire (5) fixé sur un support (6), **caractérisé par le fait que** le module solaire (5) présente un transpondeur passif (11) à la face postérieure, et ledit dispositif antivol (1) est équipé d'une unité (12) d'émission-réception qui est affectée à la transmission de données avec le transpondeur (11), est conçue pour une distance de lecture courte, est située en vis-à-vis dudit transpondeur (11), est consignée à demeure sur le support (6) et assure l'alimentation en énergie dudit transpondeur (11) sans contact, ledit transpondeur (11) et ladite unité (12) d'émission-réception étant recouverts par le module solaire (5) et étant inaccessibles tant que ledit module solaire (5) est fixé audit support (6), de telle sorte que ladite unité (12) d'émission-réception ne puisse être découplée, et que ledit transpondeur (11) ne puisse être dissocié d'avec ledit module solaire (5), qu'après dissociation préalable dudit module solaire (5) d'avec ledit support (6).

2. Dispositif antivol selon la revendication 1, **caractérisé par le fait que** le transpondeur (11) est intégré dans le module solaire (5) par stratification.

3. Dispositif antivol selon l'une des revendications 1 à 2, **caractérisé par le fait que** le transpondeur (11) est réalisé sous la forme d'une étiquette adhésive, et présente une mention imprimée ne faisant pas référence à un transpondeur (11).

4. Dispositif antivol selon l'une des revendications 1 à 3, **caractérisé par le fait que** ledit dispositif antivol (1) est doté d'une télésurveillance (15) à laquelle l'unité (12) d'émission-réception est raccordée, et qui prévient d'un éloignement du transpondeur (11) vis-à-vis de ladite unité (12) d'émission-réception.

5. Dispositif antivol selon l'une des revendications 1 à 4, **caractérisé par le fait que** l'installation photovoltaïque (2) comprend plusieurs modules solaires (5) au sein desquels des modules individuels présentent un transpondeur (11) ; et **par le fait qu'**une unité (12) d'émission-réception est assignée à chaque transpondeur (11).

6. Dispositif antivol selon la revendication 5, **caractérisé par le fait que** des modules solaires (5), situés sur le bord (16) de l'installation photovoltaïque (2), sont pourvus d'un transpondeur (11).
